# FASCICULE DE BREVET EUROPEEN

(11) **EP 3 345 305 B1**
(45) Date de publication et mention de la délivrance du brevet: **24.07.2019**
(21) Numéro de dépôt: 16770065.7
(22) Date de dépôt: 30.08.2016
(51) Int. Cl.: H04B 1/3816, G06F 1/18, H05K 5/00, H04B 1/00, H04W 88/16, H04B 7/24, H04W 84/18

(54) **ARCHITECTURE DE STATION DE BASE MODULABLE POUR RÉSEAU DE CAPTEURS SANS-FIL**
ARCHITEKTUR EINER MODULAREN BASISSTATION FÜR DRAHTLOSES SENSORNETZWERK
MODULAR BASE STATION ARCHITECTURE FOR WIRELESS SENSOR NETWORK

(30) Priorité: 31.08.2015 FR 1558081
(43) Date de publication de la demande: 11.07.2018
(73) Titulaire: Kerlink, 35235 Thorigne-Fouillard (FR)
(72) Inventeur: CHAPLET, Martin, 35235 Thorigne-Fouillard (FR); GILBERT, Michel, 35410 Chateaugiron (FR); NICOLAS, Samuel, 35510 Cesson Sevigne (FR); DUBOURG, Ronan, 35530 Noyal sur Vilaine (FR); DELIBIE, Yannick, 35235 Thorigné-Fouillard (FR)
(74) Mandataire: Loyer & Abello
(86) Numéro de dépôt international: PCT/FR2016/052152
(87) Numéro de publication internationale: WO 2017/037381

(56) Documents cités:
- EP-A2- 2 216 909
- WO-A1-02/28158
- WO-A1-2013/138360
- US-A1- 2014 024 413
- US-A1- 2014 350 768
- US-B1- 6 741 466

## Description

### 1. Domaine

Le domaine de l'invention est celui de l'Internet des objets. Il concerne plus particulièrement l'architecture des passerelles permettant la mise en oeuvre de réseaux de capteurs sans-fil, notamment à grande échelle, ainsi que l'interconnexion de tels réseaux avec d'autres réseaux, tel que le réseau Internet par exemple.

### 2. Art antérieur

L'internet des objets est en plein essor. Cette évolution s'accompagne de l'émergence de nouvelles applications, qui dépassent le simple cadre traditionnel du foyer ou de l'entreprise, pour venir s'intégrer au sein d'infrastructures beaucoup plus vastes. Le concept de « villes intelligentes » (ou « smart cities » en anglais) s'inscrit notamment dans ce cadre. Au moyen du déploiement à grande échelle de réseaux de capteurs sans fils, ou autres objets communicants, il devient ainsi possible de proposer de nouveaux services aux individus, ou aux autorités en charge d'administrer une ville. L'éventail des possibilités est large. L'éclairage urbain peut ainsi être optimisé, en l'adaptant dynamiquement en fonction de l'état du trafic routier à un instant considéré, par exemple. La gestion du stationnement peut également être facilitée, en informant en temps-réel les automobilistes des emplacements de stationnement disponibles, grâce à des capteurs intégrés à chacun de ces emplacements de stationnement. Ceci contribue par exemple à réduire la consommation de carburant des véhicules et donc la pollution.

Le déploiement de ces réseaux de capteurs sans-fil constitue une opportunité de développement particulièrement intéressante pour les opérateurs de téléphonie mobile. Ces derniers sont en effet idéalement positionnés : d'une part ils ont développé une expertise dans le domaine du déploiement de réseaux sans fil à grande échelle, d'autre part ils disposent déjà d'une partie des infrastructures nécessaires au déploiement d'un tel réseau. Par exemple, les lieux d'implantation (mats, poteaux, points hauts, etc.) des antennes relais utilisées pour la téléphonie mobile peuvent être exploitées pour accueillir également les antennes et stations de base mises en oeuvre pour assurer le fonctionnement d'un réseau de capteurs sans-fil. Ces stations de base ont pour rôle d'assurer la réception et l'émission de données en provenance et à destination des capteurs sans-fil présents dans leur zone de couverture (accès radio), mais aussi de relayer ces données à des équipements en charge de les traiter, par exemple des serveurs accessibles sur un réseau basé sur le protocole IP (« Internet Protocol »). Les stations de base ont donc aussi un rôle d'interface entre le réseau de capteurs sans-fil et d'autres réseaux, par exemple un réseau étendu tel que le réseau Internet, et on les qualifie également à ce titre de « passerelles ».

Plusieurs technologies d'accès radio sont disponibles pour la mise en oeuvre de réseaux de capteurs sans-fil. On peut citer à titre purement illustratif et non limitatif les technologies LoRa™, Sigfox™ ou encore WM-Bus (de l'anglais « *Wireless Meter Bus* »), qui reposent notamment sur des types de modulation différents. Ces technologies peuvent être opérées dans différentes bandes de fréquences radio (par exemple dans des bandes de fréquences privées, soumises à l'obtention d'une autorisation ; ou encore dans des bandes de fréquences libres telles que les bandes ISM), avec une grande variété de types d'antennes (sectorisées, polarisées, omnidirectionnelles, etc.). Aussi, il existe une multitude de configurations possibles, et la détermination de la solution technique à privilégier résulte généralement de l'appréciation de nombreux critères. Ainsi, la topographie de la zone de déploiement, la densité de capteurs à adresser, la qualité de service recherchée, mais également la réglementation en vigueur sur le territoire considéré (les bandes de fréquences libres sont différentes entre les Etats-Unis et la France par exemple), sont autant de facteurs, parmi beaucoup d'autres, à prendre en compte lors du déploiement d'un réseau de capteurs sans-fil.

Les passerelles existantes pour la mise en oeuvre de réseaux de capteurs sans-fil sont peu évolutives : elles sont pour la plupart adaptées à gérer un seul type de technologie d'accès radio, dans une seule bande de fréquences radio. Elles n'offrent généralement qu'une connectivité limitée en termes de configurations d'antennes possibles, quand elles n'imposent pas l'utilisation d'une antenne fournie. Enfin, le plus souvent, elles ne gèrent qu'un seul type d'interface (soit filaire, soit WiFi, soit 3G/4G, par exemple) avec un autre réseau (tel que le réseau Internet par exemple). Si ces passerelles sont particulièrement adaptées pour le déploiement de réseaux de capteurs sans-fil de faible ou moyenne envergure - avec des contextes d'utilisation relativement figés et maîtrisés - elles ne le sont plus pour le déploiement de réseau de capteurs sans-fil sur des zones très étendues et en évolution constante - par exemple au niveau d'une ville entière - qui exige une réactivité et une adaptabilité importante. Ces passerelles existantes, qui doivent être intégralement remplacées au moindre besoin d'évolution du réseau, ne permettent donc pas de faire face aux différentes problématiques amenées à se poser avec l'essor programmé des réseaux dédiés à l'Internet des objets : augmentation constante et importante du nombre de capteurs à gérer au sein d'un même territoire, diversité des technologies d'accès radios à prendre en charge, diversité des bandes de fréquences utilisées, diversité des types d'antennes à gérer, etc.

US2014/0 024 413 dévoile un dispositif radio modulaire en trois parties qui peuvent être échangées en fonction des besoins.

EP 2 216 909 dévoile un dispositif modulaire de radiocommunication pour l'aviation civile. Ce document ne montre pas comment optimiser l'espace occupé par les différents modules.

US 6 741 466 dévoile un système électronique modulaire disposant d'un châssis principal recevant les différents modules.

US 2014/0 350 768 dévoile un module de contrôle robotique amovible.

WO 2013/138 360 dévoile un ordinateur modulaire comprenant des éléments qui viennent se connecter les uns aux autres.

WO 02/28 158 dévoile un système électronique modulaire qui comporte des modules de forme similaire afin d'optimiser l'espace occupé.

Il existe donc un besoin d'un nouveau type de passerelles pour des réseaux de capteurs sans-fil ou autres objets communicants, qui offre une adaptabilité suffisante pour permettre aux fournisseurs de solutions dans l'Internet des objets à grande échelle de faire évoluer simplement, rapidement, et à moindre coût un réseau déjà déployé ; il existe également un besoin de transposer facilement une solution d'un territoire à un autre, malgré les différences (topographique, réglementaire, etc.) que ces territoires peuvent présenter, afin de répondre plus facilement aux exigences et attentes de ces nouveaux territoires.

### 2. Résumé

La technique proposée offre une solution qui ne présente pas au moins certains de ces problèmes de l'art antérieur, grâce à une architecture de passerelle pour réseau de capteurs sans-fil modulable.

Selon un premier aspect, la technique proposée se rapporte à un modem radio numérique pour la modulation et la démodulation d'un signal numérique en fonction d'une technologie d'accès radio préalablement sélectionnée, ledit modem radio numérique étant caractérisé en ce qu'il comprend un châssis de protection et une pluralité d'interfaces de communication aménagées au sein dudit châssis.

Ainsi, le modem radio numérique selon la technique proposée n'est pas intégré au sein d'un circuit imprimé par exemple : il dispose d'un châssis qui lui est propre, au sein duquel sont aménagées différentes interfaces de communication. De cette manière, le modem radio numérique bénéficie d'une certaine souplesse quant à son utilisation : il forme un bloc physique indépendant qui peut être assemblé ou désassemblé facilement dans le cadre de la mise en oeuvre d'une passerelle pour réseau de capteurs sans-fil.

Dans un mode de réalisation particulier de la technique proposée, ladite pluralité d'interfaces de communication comprend au moins une première interface de communication avec un dispositif complémentaire, et au moins une deuxième interface de communication avec un module d'interface radio analogique.

Ainsi, le modem radio numérique dispose d'au moins deux interfaces de communication.

La première interface de communication lui permet d'être connecté avec un dispositif complémentaire, qui peut-être soit un dispositif du même type (à savoir un autre modem radio numérique selon la technique proposée), soit un dispositif d'un autre type (par exemple un dispositif de contrôle, un dispositif d'alimentation électrique, ou encore un dispositif permettant de gérer la connexion à un autre réseau de communication). Dans le premier cas, les modems radio numériques sont connectés entre eux par coopération des premières interfaces de communication respectives desdits dispositifs. Dans le deuxième cas, le dispositif complémentaire auquel est connecté le modem radio numérique selon la technique proposée comprend lui même au moins une interface de communication lui permettant coopérer avec ladite au moins une première interface de communication du modem radio numérique. Cette première interface de communication prend par exemple la forme d'un connecteur SPI (de l'anglais « Serial Peripheral Interface »). De cette manière, les dispositifs ainsi connectés partagent au moins un bus de données commun.

La deuxième interface de communication permet quant à elle de connecter le modem radio numérique avec un module d'interface radio analogique. De cette manière, par assemblage de ces deux blocs physiques indépendants, il est possible de former un dispositif d'interface radio permettant, par l'adjonction d'une antenne, de recevoir et d'émettre des données en provenance ou à destination d'au moins un capteur distant. Cette deuxième interface de communication peut également prendre la forme d'un connecteur SPI (de l'anglais « Serial Peripheral Interface »), permettant alors la création d'un bus de données entre ces deux éléments, une fois connectés entre eux.

Dans un autre mode de réalisation particulier de la technique proposée, le modem radio numérique comprend au moins deux premières interfaces de communication avec un dispositif complémentaire, ces interfaces de communication formant des extrémités d'au moins un bus de données utilisé par ledit modem radio numérique pour transmettre et/ou recevoir des données à destination et/ou en provenance d'au moins un dispositif complémentaire.

De cette manière, par la présence de ces au moins deux premières interfaces de communication, il devient possible de chaîner entre eux plusieurs modems radio numériques selon la technique proposée, mais également de les chaîner avec des dispositifs complémentaires compatibles d'autres types, de sorte que l'ensemble des dispositifs ainsi connectés partagent au moins un bus de données commun.

Dans encore un mode de réalisation particulier de la technique proposée, le modem radio numérique est caractérisé en ce que ladite technologie d'accès radio préalablement sélectionnée appartient au groupe comprenant :
- la technologie LoRa™ ;
- la technologie Sigfox™ ;
- la technologie WM-BUS.

Ainsi, le modem radio numérique selon la technique proposée est particulièrement adapté dans le cadre du développement de l'Internet des objets, c'est à dire pour la mise en oeuvre de réseaux de communication sans-fil basés sur des protocoles de communication optimisés pour minimiser la consommation électrique des capteurs et autres objets communicants utilisés.

Dans un autre mode de réalisation particulier de la technique proposée, cette technologie d'accès radio préalablement sélectionnée est choisie parmi un ensemble de technologies d'accès radio prédéfinies au sein dudit modem radio numérique.

De cette manière, un même modem radio numérique peut prendre en charge différentes technologies d'accès radio, et donc être utilisé différemment dans différents contextes via une simple étape de configuration. Ceci permet notamment d'optimiser les coûts de fabrication et de faciliter l'installation de ces dispositifs.

Selon un deuxième aspect, la technique proposée se rapporte à un module d'interface radio analogique qui comprend un châssis de protection, des moyens de connexion à au moins une antenne, et au moins une troisième interface de communication avec un modem radio numérique tel que décrit précédemment, lesdits moyens de connexion à au moins une antenne et ladite au moins une troisième interface de communication étant aménagés au sein dudit châssis.

Ainsi, le module d'interface radio analogique n'est pas intégré au sein d'un circuit imprimé par exemple : il dispose d'un châssis qui lui est propre, au sein duquel est aménagée au moins une interface de communication avec un modem radio numérique selon la technique proposée. De cette manière, le module d'interface radio analogique selon la technique proposée forme un bloc physique indépendant, ce qui procure une évidente souplesse quant à son utilisation : il peut être déconnecté et reconnecté facilement à un ou plusieurs modems radio numériques. Il comprend en outre des moyens de connexion à au moins une antenne qui le rende apte à gérer différentes configurations d'antennes.

Selon encore un aspect, la technique proposée se rapporte à un dispositif d'interface radio pour la réception et la transmission de données en provenance et à destination d'au moins un capteur sans-fil, qui comprend au moins un modem radio numérique tel que décrit précédemment et un module d'interface radio analogique tel que décrit précédemment. Le module d'interface radio analogique est connecté audit au moins un modem radio numérique au moyen d'une coopération de leurs deuxième et troisième interfaces de communication.

De cette manière, il est possible de former un dispositif d'interface radio par assemblage d'un ou plusieurs modems radio numériques de même type (même technologie d'accès radio) avec un module d'interface radio analogique selon la technique proposée. Le fait que ces différents blocs physiques disposent chacun d'un châssis propres comprenant des interfaces de communication complémentaires permet d'obtenir une solution de grande modularité. Ainsi, il est possible de s'adapter très simplement à un grand nombre de situations, par simple choix d'un type de modem radio numérique et d'un type de module d'interface radio analogique à assembler. Le choix du type du modem radio numérique permet ainsi de définir la technologie d'accès radio à utiliser (en fonction des fonctionnalités offerte par ce modem radio numérique, une simple configuration logicielle peut suffire). Le choix du type du module d'interface radio analogique permet quant à lui de définir d'une part la bande de fréquence qui doit être utilisée pour la transmission radio, et d'autre part la typologie de configuration d'antennes retenue (antenne sectorisée, polarisée, omnidirectionnelle, etc.).

Dans un mode de réalisation particulier, un tel dispositif d'interface radio comprend une pluralité de modems radio numériques selon la technique proposée, associés à une même technologie d'accès radio, les modems radio numériques qui forment ladite pluralité de modems radio numériques étant connectés entre eux au moyen de leurs premières interfaces de communication.

Ainsi, il est possible de connecter facilement entre eux plusieurs modems radio numériques d'un même type selon la technique proposée, et d'associer l'ensemble à un même module d'interface radio analogique. De cette manière, il est possible d'augmenter la capacité de charge d'un dispositif d'interface radio, par simple adjonction d'un modem radio numérique supplémentaire à l'installation existante : ainsi la solution de la technique proposée permet par exemple de répondre très simplement à une évolution du nombre de capteurs sans-fil à gérer sur un territoire donné, couvert par une même antenne.

Dans encore un autre aspect, la technique proposée se rapporte à une passerelle pour l'interconnexion d'au moins un réseau de capteurs sans-fil avec au moins un réseau de communication étendu, ladite passerelle étant caractérisé en ce qu'elle comprend :
- au moins un dispositif d'interface radio selon la technique proposée ;
- au moins un dispositif complémentaire d'interface avec ledit au moins un réseau de communication étendu, ce dispositif complémentaire comprenant au moins une quatrième interface de communication, ledit dispositif complémentaire étant connecté audit au moins un dispositif d'interface radio au moyen d'une coopération de ladite quatrième interface de communication avec une première interface de communication d'un modem radio numérique dudit dispositif d'interface radio.

De cette manière, il est possible de construire une passerelle permettant l'interconnexion d'au moins un réseau de capteurs sans-fil avec au moins un autre réseau de communication étendu, par simple assemblage de dispositifs d'interface radio (eux-même obtenus par simple assemblage de modems radio numériques avec des modules d'interface radio analogiques) avec au moins un dispositif complémentaire compatible gérant l'accès au réseau étendu. Les interfaces de communication présentes à la fois sur les dispositifs complémentaires et sur les modems radio numériques compris au sein des dispositifs d'interface radio permettent l'interconnexion de tous ces éléments, par la formation d'un bus de données commun, par exemple de type SPI. D'autres types de dispositifs complémentaires, également dotés d'interfaces de communication compatibles, peuvent également accéder à ce bus de donnés partagé, et permettre ainsi de finaliser l'assemblage de la passerelle : à titre d'exemple, on peut citer un dispositif complémentaire permettant d'assurer l'alimentation électrique de l'ensemble de la passerelle, ou encore un dispositif complémentaire de contrôle visant à superviser le fonctionnement de l'ensemble des autres dispositifs complémentaires et dispositifs d'interfaces radio compris dans la passerelle, et à contrôler les échanges de données réalisés entre tous ces différents éléments.

Dans un mode de réalisation particulier, une telle passerelle comprend une pluralité de dispositifs d'interface radio selon la technique proposée, lesdits dispositifs d'interface radio de ladite pluralité de dispositifs d'interface radio étant connectés entre eux au moyen d'une coopération de premières interfaces de communication des modems radio numériques de ladite pluralité de dispositifs d'interface radio.

Ainsi, une même passerelle peut comprendre une chaîne de plusieurs dispositifs d'interface radio selon la technique proposée, et être ainsi adaptable à un encore plus grand nombre de situations. De cette manière, il est par exemple possible de rassembler au sein d'une même passerelle des dispositifs d'interface radio basés sur des technologies d'accès radio hétérogènes. Cette souplesse de connexion permet également d'assembler une passerelle apte à gérer plusieurs bandes de fréquences différentes. Elle permet aussi de mettre en oeuvre une sectorisation, de manière par exemple à assurer une meilleure couverture du territoire. Tous ces exemples sont bien entendu donnés à titre purement illustratif et non limitatif, et l'Homme du Métier appréciera les multiples possibilités de configurations qu'offre une passerelle assemblée selon la technique proposée.

Les différents modes de réalisation mentionnés ci-dessus sont combinables entre eux pour la mise en oeuvre de l'invention.

### 4. Liste des figures

D'autres caractéristiques et avantages de l'invention apparaîtront plus clairement à la lecture de la description suivante d'un mode de réalisation préférentiel de l'invention, donné à titre de simple exemple illustratif et non limitatif, et des dessins annexés parmi lesquels :
- la figure 1 présente une vue simplifiée des principaux modules d'une passerelle pour la mis en oeuvre d'un réseau de capteurs sans-fil ;
- les figures 2a et 2b présentent différentes vues d'un modem radio numérique, dans un mode de réalisation particulier de la technique proposée ;
- les figures 3a et 3b présentent différentes vues d'un module d'interface radio analogique, dans un mode de réalisation particulier de la technique proposée ;
- les figures 3c et 3d présentent différentes vues d'un module d'interface radio analogique, dans un autre mode de réalisation particulier de la technique proposée ;
- la figure 4a illustre un exemple d'assemblage en cours d'un module d'interface radio analogique sur un modem radio numérique, permettant l'obtention d'un dispositif d'interface radio, dans un mode de réalisation particulier de la technique proposée ;
- la figure 4b illustre un exemple d'assemblage d'un module d'interface radio analogique sur un bloc de plusieurs modems radio numériques interconnectés, permettant l'obtention d'un dispositif d'interface radio, dans un autre mode de réalisation particulier de la technique proposée ;
- les figures 5a à 5c présentent différents exemples de passerelles pour la mise en oeuvre d'un réseau de capteurs sans-fil, obtenues par assemblage de modems radio numériques, de dispositifs complémentaires, et de modules d'interface radio analogique selon la technique proposée, dans un mode de réalisation particulier.

### 5. Description détaillée

La technique proposée se rapporte à une architecture originale de station de base pour la mise en oeuvre de réseaux de capteurs, ou autres objets communicants, sans-fil. Dans l'ensemble du document, une telle station de base est également dénommée « passerelle », et on utilise le terme « réseau de capteurs sans-fil » pour désigner indifféremment un réseaux de capteurs sans-fil ou un réseau d'objets communicants - éventuellement plus complexes - sans fil. L'architecture proposée repose sur la séparation des principales fonctionnalités classique d'une passerelle en différents blocs physiques, disposant chacun de leur propre châssis au sein duquel sont aménagées différentes interfaces de communication, de sorte que ces différents blocs physiques soient interconnectables. Cette conception permet non seulement de construire simplement et rapidement des passerelles « sur-mesure », permettant de répondre à de nombreux types de besoin, mais également de conférer à ces passerelles une grande modularité et une grande évolutivité. L'architecture proposée permet en effet de remplacer très facilement un bloc physique par un autre, ou d'adjoindre un nouveau bloc physique à une passerelle déjà constituée. A ce titre, elle est particulièrement adaptée au déploiement de réseaux de capteurs sans-fil à grande échelle (même si elle peut également être utilisée dans le cadre du déploiement de réseaux de capteurs sans-fil de moindre envergure).

### 5.1. Description des éléments constitutifs d'une passerelle

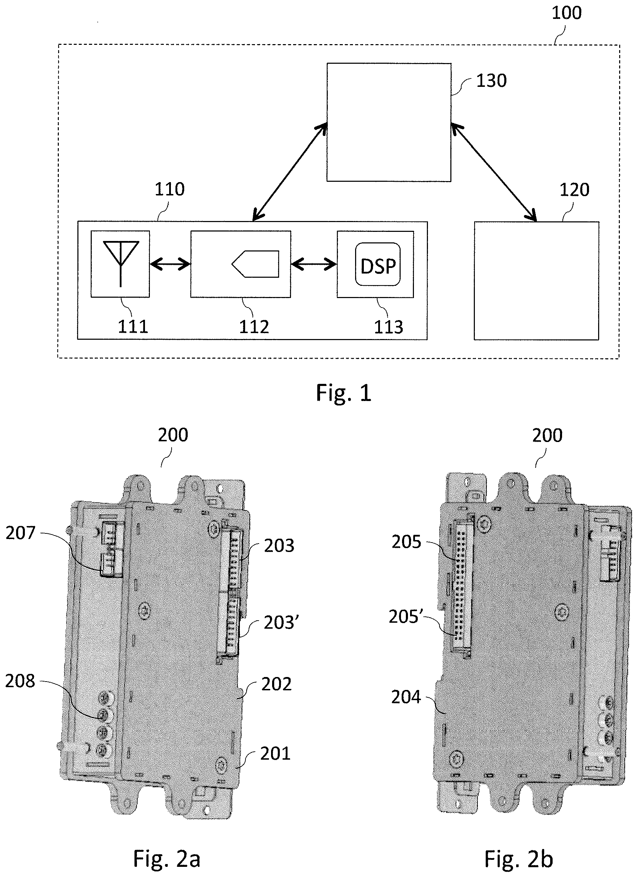

On présente, en relation avec la **figure** 1, une vue schématique simplifiée des principaux modules mis en oeuvre au sein d'une passerelle pour réseau de capteurs sans-fil. Une telle passerelle (100) comprend :
- un premier module d'interface (110) avec le réseau de capteurs sans-fil ;
- au moins un deuxième module d'interface (120) avec un autre réseau, par exemple un réseau IP local ou un réseau étendu tel que le réseau Internet;
- un module de commande (130), destiné à contrôler les modules d'interface précédemment cités.

Le premier module d'interface (110) avec le réseau de capteurs sans-fil constitue le dispositif d'accès radio de la passerelle. Il est destiné à assurer les échanges de données entre la passerelle et les capteurs sans-fil, via un canal de transmission radio. Il comprend les principaux sous-modules suivants :
- une antenne (111), destinée à rayonner ou à capter les ondes radio véhiculant les données à échanger;
- un module d'interface radio analogique (112), qui constitue le système frontal analogique radiofréquence, en charge d'effectuer les traitements du signal analogique délivré par ou fourni à l'antenne, dans la bande de fréquence utilisée pour la transmission radio (ces traitements peuvent consister en du filtrage, de la transposition de fréquence, de l'amplification de puissance, etc.) ; le module d'interface radio analogique réalise également des conversions analogique vers numérique (lors de la réception de données en provenances des capteurs) et numérique vers analogique (lors de la transmission de données à destination des capteurs) ;
- un modem radio numérique (113) qui permet d'assurer notamment la modulation et la démodulation des signaux numériques selon la technologie d'accès radio utilisée, par exemple au moyen d'un processeur de signal numérique (DSP, de l'anglais « Digital Signal Processor »).

Dans la plupart des passerelles pour réseaux de capteurs sans-fil existantes, ces éléments sont généralement mis en oeuvre par des circuits électroniques présents sur une même carte électronique, ou du moins intégrés au sein d'un même châssis (à l'exception de l'antenne qui est ou bien solidarisée audit châssis, ou bien connectée audit châssis au moyen d'un connecteur dédié aménagé au sein de ce châssis). Cette intégration poussée fait que ces passerelles sont adaptées pour répondre à des besoins très spécifiques (utilisation d'une technologie d'accès radio donnée, dans une bande de fréquences donnée), mais qu'elles ne répondent pas au besoin d'adaptabilité et d'évolutivité requis pour le déploiement de réseaux de capteurs sans-fil à grande échelle.

### 5.2. Principe général de la technique proposée

La technique décrite ici se propose de remédier au moins en partie à ce problème, d'une part par la séparation physique, dans des châssis (ou boîtiers) distincts, des modules analogique (c'est à dire le module d'interface radio analogique qui constitue le système frontal analogique) et numérique (c'est à dire le modem radio numérique) d'un dispositif d'interface radio ; et d'autre part par la mise en oeuvre de moyens permettant de connecter simplement plusieurs dispositifs d'interface radio entre eux, mais également à des dispositifs complémentaires tels que des dispositifs de contrôle ou des dispositifs d'interface avec un réseau étendu. Le principe général de la technique proposée consiste donc à isoler les principaux modules mis en oeuvre au sein d'une passerelle pour réseau de capteurs sans-fil dans différents blocs physiques indépendants pouvant être assemblés entre eux. Par cette technique, on permet ainsi la mise en oeuvre de passerelles pour réseaux de capteurs sans-fil modulables et évolutives, qui peuvent être configurées ou adaptées facilement et rapidement pour répondre à tout type de situation, par simple remplacement de blocs physiques existants ou adjonction de nouveaux blocs physiques.

### 5.3. Modem radio numérique

A cette fin, un dispositif de modulation et de démodulation d'un signal numérique (également appelé modem radio numérique dans la suite du document) est proposé, selon un premier aspect de la technique décrite. Ce modem radio numérique est configuré pour opérer selon une technologie d'accès radio préalablement sélectionnée, par exemple la technologie LoRa™, Sigfox™ ou encore WM-Bus, qui sont autant de technologies particulièrement adaptées à la mise en oeuvre de réseaux de capteurs sans-fil. Il comprend un châssis, qui protège l'électronique nécessaire à son fonctionnement, et forme ainsi un bloc physique indépendant. Une pluralité d'interfaces de communication est aménagée au sein de ce châssis, ce qui permet de connecter ou de déconnecter très simplement le modem radio numérique au reste d'un système. Par « interfaces de communication », on entend ici et pour toute la suite du document des interfaces de nature physique utilisées pour interconnecter physiquement plusieurs dispositifs électroniques entre eux. Ces interfaces de communication peuvent par exemple prendre la forme de connecteurs de liaison série (tel que des connecteurs SPI, de l'anglais « Serial Peripheral Interface »), qui permettent la formation d'un bus de données commun partagé entre tous les dispositifs ainsi interconnectés.

Dans un mode de réalisation particulier de la technique proposée, le modem radio numérique comprend au moins une première interface de communication avec un dispositif complémentaire, et au moins une deuxième interface de communication avec un module d'interface radio analogique.

La première interface de communication présente sur le modem radio numérique permet de le connecter à un dispositif complémentaire, qui peut-être ou bien un dispositif du même type (à savoir un autre modem radio numérique selon la technique proposée), ou bien un dispositif d'un autre type (par exemple un dispositif de contrôle, un dispositif d'alimentation électrique, ou encore un dispositif permettant de gérer un type d'interface - par exemple Ethernet, Wifi, ou 3G/4G - avec un autre réseau). Dans le premier cas, les modems radio numériques sont connectés entre eux par coopération des premières interfaces de communication respectivement présentes sur chacun desdits dispositifs. Dans le deuxième cas, le dispositif complémentaire auquel est connecté le modem radio numérique est un dispositif dit compatible, dans le sens où il comprend lui même au moins une interface de communication lui permettant de coopérer avec une première interface de communication du modem radio numérique selon la technique proposée. Ces interfaces de communication peuvent par exemple prendre la forme de connecteurs SPI, et participer ainsi à la formation d'un bus de données commun partagé entre les dispositifs, une fois ceux-ci connectés.

La deuxième interface de communication présente sur le modem radio numérique permet de le connecter à un module d'interface radio analogique compatible, tel que décrit ultérieurement dans le présent document. De cette manière, il est possible de former un dispositif d'interface radio permettant, par la simple adjonction d'une ou plusieurs antennes, de recevoir et d'émettre des données en provenance ou à destination d'au moins un capteur sans-fil distant. A titre d'exemple, cette deuxième interface de communication peut également prendre la forme d'un connecteur SPI.

Dans un mode de réalisation particulier de la technique proposée, le modem radio numérique comprend au moins deux premières interfaces de communication avec un dispositif complémentaire, ce qui lui permet donc de communiquer avec au moins deux dispositifs complémentaires. Ces interfaces de communication sont chacune situées à l'extrémité d'au moins un bus de données qui permet audit modem radio numérique d'échanger des données avec des dispositifs complémentaires. De cette manière, un même modem radio numérique peut être connecté à plusieurs dispositifs complémentaires, qui peuvent être d'autres dispositifs du même type (c'est à dire d'autres modems radio numériques selon la technique proposée), ou encore d'autres dispositifs compatibles. Ainsi, il devient possible de chaîner plusieurs dispositifs, de sortes qu'ils partagent tous au moins un bus de données commun (par exemple un bus SPI), ce qui permet à tous les dispositifs ainsi interconnectés d'échanger des données entre eux. Préférentiellement, les dispositifs complémentaires dits compatibles (autres que les modems radio numériques) comprennent également au moins deux interfaces de communication aptes à coopérer avec les premières interfaces de communication d'un modem radio numérique selon la technique proposée, de sorte qu'il est possible de chaîner les différents dispositifs dans n'importe quel ordre.

Dans un autre mode de réalisation particulier de la technique proposée, la technologie d'accès radio mise en oeuvre au sein du modem radio numérique peut être sélectionnée logiciellement au sein d'un groupe de technologies d'accès radio prédéfinies (c'est-à-dire pré-paramétrées, préenregistrées, ou accessibles) au sein dudit modem radio numérique. Le modem radio numérique embarque alors l'électronique suffisante pour lui permettre de gérer plusieurs types de modulation et démodulation numériques; et il est possible de configurer, de manière logicielle, le type qui doit être utilisé. De cette manière, un même modem radio numérique peut prendre en charge différentes technologies d'accès radio, et donc être employé différemment dans différents contextes. Ceci peut également permettre d'optimiser les coûts de fabrication de ces dispositifs.

### 5.4. Module d'interface radio analogique

Selon un autre aspect, la technique proposée se rapporte également à un module d'interface radio analogique. Ce module - qui fait office de système frontal analogique pour l'adaptation à la bande de fréquences utilisée pour la transmission radio - est destiné à être utilisé en complément d'au moins un modem radio numérique selon la technique proposée. Il comprend un châssis, qui intègre l'électronique nécessaire à son fonctionnement, et forme ainsi un bloc physique indépendant. Il comprend également, aménagés au sein de ce châssis, des moyens de connexion à au moins une antenne, ainsi qu'au moins une troisième interface de communication avec un modem radio numérique tel que décrit précédemment.

Le rôle de ce module d'interface radio analogique est de gérer l'adaptation à la bande de fréquences utilisée pour la transmission radio, et de fournir la connectivité nécessaire à la prise en charge de différentes typologies d'antennes (omnidirectionnelle, polarisée, sectorisée). Aussi, selon différents modes de réalisation particuliers d'un module d'interface radio analogique selon la technique proposée, la bande de fréquences prise en charge par ce module, le nombre de troisièmes interfaces de communication et le type de moyens de connexion à au moins une antenne disponibles peuvent varier. Ainsi, la technique proposée permet de disposer d'une large gamme de modules d'interface radio analogique, présentés sous la forme d'autant de blocs physiques indépendants, qui peuvent coopérer avec un ou plusieurs modems radio numériques, afin de pouvoir couvrir tout type de situation tant en termes de bandes de fréquences que de typologie d'antennes à utiliser.

### 5.5. Dispositif d'interface radio

Selon encore un autre aspect, la technique proposée se rapporte également à un dispositif d'interface radio pour la réception et la transmission de données en provenance et à destination d'au moins un capteur sans-fil. Un tel dispositif d'interface radio comprend :
- au moins un modem radio numérique selon la technique proposée ;
- un module d'interface radio analogique selon la technique proposée.

Le module d'interface radio analogique est connecté audit au moins un modem radio numérique au moyen d'une coopération desdites deuxième et troisième interfaces de communication.

Ainsi, il est possible de former un dispositif d'interface radio par assemblage d'au moins un modem radio numérique avec un module d'interface radio analogique selon la technique proposée. Le fait que ces éléments disposent chacun d'un châssis propre comprenant des interfaces de communication complémentaires permet d'obtenir une solution de grande modularité. Ainsi, il est possible de s'adapter simplement à un grand nombre de situations, par simple choix de blocs physique à assembler, à savoir le choix d'un modem radio numérique et le choix d'un module d'interface radio analogique à assembler. Le choix du modem radio numérique permet ainsi de définir la technologie d'accès radio à utiliser (en fonction des fonctionnalités offerte par ce modem radio numérique, une simple configuration logicielle peut suffire). Le choix du module d'interface radio analogique permet quant à lui de définir d'une part la bande de fréquence qui doit être utilisée pour la transmission radio, et d'autre part le type de configuration d'antennes retenu (antenne sectorisée, polarisée, omnidirectionnelle, etc.).

Dans un mode de réalisation particulier de la technique proposée, le dispositif d'interface radio comprend une pluralité de modems radio numériques selon la technique décrite. Ces modems radio numériques sont alors tous du même type (même technologie d'accès radio), et ils sont connectés entre eux au moyen de leurs premières interfaces de communication. Il est ainsi aisé d'assembler ou de faire évoluer un dispositif d'interface radio, de sorte qu'il soit toujours dimensionné pour répondre à une évolution du nombre de capteurs sans-fil à gérer sur un territoire donné, couvert par une même antenne. La technique proposée permet en effet de connecter facilement entre eux plusieurs modems radio numériques, et d'associer l'ensemble à un même module d'interface radio analogique. De cette manière, il est possible d'augmenter la capacité de charge d'un dispositif d'interface radio, par simple adjonction d'un modem radio numérique supplémentaire à une installation existante.

### 5.6. Passerelle pour réseaux de capteurs sans-fil

La technique proposée se rapporte également à une passerelle pour réseaux de capteurs sans-fil. Cette passerelle permet notamment l'interconnexion d'au moins un réseau de capteurs sans-fil avec au moins un autre réseau de communication étendu, et elle comprend à cet effet au moins un dispositif d'interface radio tel que décrit précédemment, pour l'échange de données avec lesdits capteurs sans-fil, et au moins un dispositif complémentaire d'interface avec un réseau de communication étendu. Le dispositif complémentaire est un dispositif compatible tel que déjà introduit dans le présent document, et il comprend donc au moins une interface de communication lui permettant de se connecter à une première interface de communication disponible d'un modem radio numérique compris dans le dispositif d'interface radio. D'autres types de dispositifs complémentaires, également dotés d'interfaces de communication compatibles, peuvent également être intégrés à la passerelle : à titre d'exemple, on peut citer un dispositif complémentaire permettant d'assurer l'alimentation électrique de l'ensemble de la passerelle, ou encore un dispositif complémentaire de contrôle apte à superviser le fonctionnement de l'ensemble des autres dispositifs complémentaires et dispositifs d'interfaces radio compris dans la passerelle, et à contrôler les échanges de données réalisés entre tous ces différents éléments.

Dans un mode de réalisation particulier, une même passerelle selon la technique proposée peut comprendre une pluralité de dispositifs d'interface radio, connectés entre eux au moyens d'une coopération de premières interfaces de communication disponibles au sein de modems radio numériques compris au sein de chaque dispositif d'interface radio. De cette manière, il est par exemple possible de chaîner au sein d'une même passerelle des dispositifs d'interface radio basés sur des technologies d'accès radio hétérogènes. Cette souplesse de connexion permet également d'assembler une passerelle apte à gérer plusieurs bandes de fréquences différentes. Elle permet aussi de mettre en oeuvre une sectorisation, de manière par exemple à assurer une meilleure couverture du territoire. Tous ces exemples sont bien entendu donnés à titre purement illustratif et non limitatif, et l'Homme du Métier appréciera les multiples possibilités de configurations qu'offre une passerelle assemblée selon la technique proposée.

### 5.7. Description d'un mode de réalisation particulier de la technique proposée

On présente, en relation avec l'ensemble des figures 2 à 5, un exemple d'implémentation de la technique proposée, permettant d'atteindre l'objectif d'une passerelle modulable et évolutive à même de répondre aux enjeux soulevés par le déploiement à grande échelle de réseaux de capteurs sans-fil.

### 5.7.1 Modem radio numérique

On présente, en relation avec les **figures 2a et 2b****,** un modem radio numérique (200) montré sous différentes vues, selon un mode de réalisation particulier de la technique proposée. Dans cet exemple, donné à titre purement illustratif et non limitatif, ce modem radio numérique (200) présente un châssis de protection (201) de forme globalement parallélépipédique qui comprend :
- sur une de ses faces, dite face supérieure (202), deux connecteurs SPI mâles (203, 203') ;
- sur la face opposée à ladite face supérieure, dite face inférieure (204), deux connecteurs SPI femelle (205, 205'), apte à coopérer avec les deux connecteurs SPI mâles (203, 203') d'un autre modem radio numérique selon le mode de réalisation décrit, lorsque ces dispositifs sont connectés.

Les connecteurs SPI mâles (203, 203') et femelles (205, 205') forment des extrémités respectives d'au moins un bus de données SPI (de l'anglais « Serial *Peripheral Interface* »), interne au châssis, utilisé par le modem radio numérique pour transmettre et recevoir des données à destination et en provenance d'autres dispositif complémentaires (qui peuvent notamment être d'autres modems radio numériques selon le mode de réalisation particulier présentement exposé).

Par ailleurs, le châssis comprend également, sur une de ses faces latérales, dite face arrière (206), au moins un autre connecteur SPI (207) et au moins un connecteur coaxial (208). Ces connecteurs sont destinés à coopérer avec des connecteurs complémentaires présents sur un module d'interface radio analogique tel que décrit ci-après.

### 5.7.2 Module d'interface radio analogique

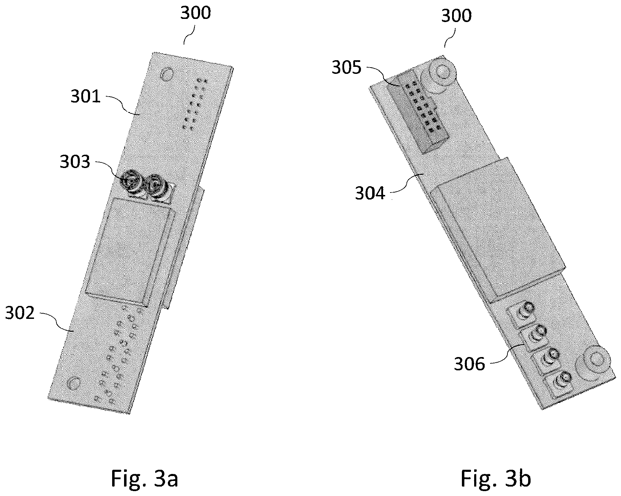

On présente maintenant, en relation avec les figures 3a à 3d, deux exemples de modules d'interfaces radio analogique aptes à coopérer avec un ou plusieurs modems radio numériques selon le mode de réalisation particulier exposé.

Les **figures 3a et 3b** illustrent différentes vues d'un premier exemple de module d'interface radio analogique (300) apte à coopérer avec un modem radio numérique, selon un mode de réalisation particulier de la technique proposée. Dans cet exemple, donné à titre purement illustratif et non limitatif, ce module (300) présente un châssis de protection (301) de forme globalement parallélépipédique, et il comprend :
- sur une de ces faces, dite face arrière (302), au moins un connecteur coaxial (303) destiné au branchement d'au moins une antenne.
- sur la face opposée à ladite face arrière, dite face avant (304), au moins un connecteur SPI (305) et au moins un connecteur coaxial (306), ces connecteurs (305, 306) étant apte à coopérer respectivement avec les connecteurs respectifs complémentaires présents sur la face arrière d'un modem radio numérique tel que décrit précédemment.

Ce module d'interface radio analogique (300) est dimensionné et conformé de sorte qu'une fois connecté à modem radio numérique selon le mode de réalisation particulier illustré ici, l'ensemble formé par ces deux éléments constitue un bloc solidaire de forme globalement parallélépipédique. A cette fin, la face avant (304) du module d'interface radio analogique est de dimension sensiblement équivalente à celle de la face arrière du modem radio numérique.

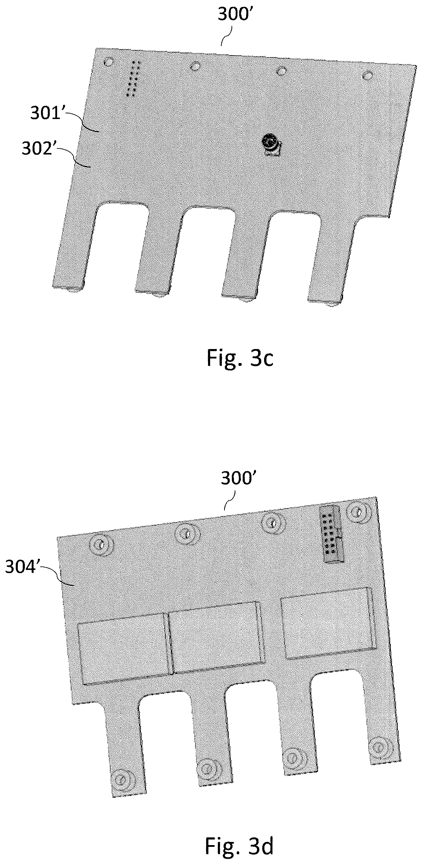

On présente, en relation avec les **figures 3c et 3d****,** un autre exemple de module d'interface radio analogique apte à être utilisé dans le cadre du mode de réalisation particulier de la technique proposée décrit ici. Dans ce mode de réalisation particulier, le module d'interface radio analogique (300') est apte à coopérer non plus avec un unique modem radio numérique, mais avec une pluralité de modems radio numériques (quatre, dans l'exemple illustré). Le châssis de protection (301') de ce module est de forme globalement parallélépipédique, et sa face avant (304') est de dimension sensiblement équivalente à celle de quatre faces arrière de modems radio numériques disposés côte-à-côte. Ce module est dimensionné et conformé de sorte qu'une fois connecté à un bloc de quatremodems radio numériques, l'ensemble formé par tous ces éléments constitue un bloc solidaire de forme globalement parallélépipédique. Le module d'interface radio analogique comprend sur sa face arrière au moins un connecteur coaxial destiné au branchement d'au moins une antenne, et sur sa face avant au moins un connecteur destiné à coopérer avec au moins un connecteur respectif complémentaire présent sur la face arrière d'au moins un des modems radio numériques auquel ce module est connecté.

Ces exemples sont donnés à titre purement illustratif et non limitatif, et d'autres types de modules d'interface radio analogique, conformés et dimensionnés pour être connectés à un nombre différent de modems radio numériques, peuvent également être mis en oeuvre dans le cadre de la technique proposée (par exemple un module d'interface radio analogique qui coopère avec deux modems radio numériques interconnectés, ou un module d'interface radio analogique qui coopère avec quatre modems radio numériques interconnectés). A des fins de simplification, on définit par « module d'interface radio analogique de dimension N » un module d'interface radio analogique spécialement conçu pour être connecté simultanément à un nombre N de modems radio numériques interconnectés. Dans un mode de réalisation particulier de la technique proposée, le châssis d'un module d'interface radio analogique de dimension N est dimensionné et conformé de sorte que sa face avant présente une dimension sensiblement équivalente à celle de N faces arrière de modems radio numériques disposés côte-à-côte. Ceci permet de conserver des formes de dispositifs d'interface radio globalement parallélépipédiques, même lorsqu'on connecte un même module d'interface radio analogique à plusieurs modems radio numériques.

### 5.7.3 Dispositif d'interface radio

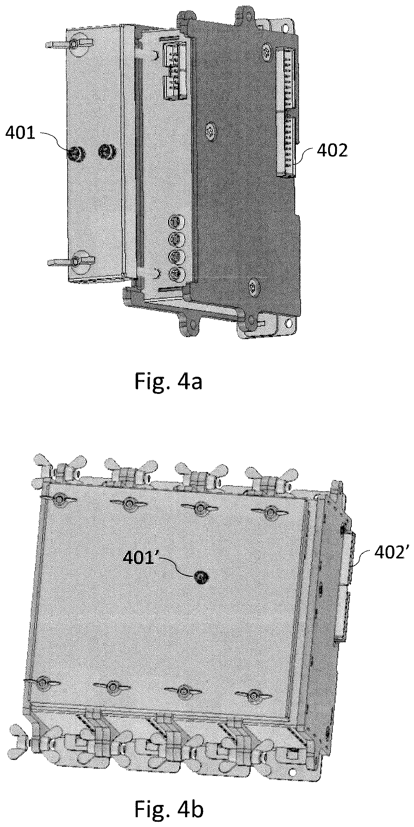

Les **figures 4a et 4b** illustrent deux exemples assemblages d'un module d'interface radio analogique avec au moins un modem radio numérique selon la technique proposée, afin de former un dispositif d'interface radio pour la réception et la transmission de données en provenance et à destination d'au moins un capteur sans-fil. La figure 4a décrit ainsi la connexion d'un module d'interface radio analogique de dimension un sur un unique modem radio numérique. La figure 4b décrit quant à elle la connexion d'un module d'interface radio analogique de dimension trois sur un bloc comprenant trois modems radio numériques interconnectés au moyens des connecteurs SPI mâles et femelles présents sur leurs faces supérieures et inférieures. Dans le cas d'une connexion d'un même module d'interface radio analogique à plusieurs modems radio numériques interconnectés, comme illustré en figure 4b, ces différents modems radio numériques sont tous du même type, c'est à dire qu'ils sont associés à une même technologie d'accès radio. Les connecteurs coaxiaux restants disponibles sur la face arrière du module d'interface radio analogique sont utilisés pour la connexion d'au moins une antenne. Les connecteurs SPI (402, 402') restant disponibles de part et d'autre du dispositif d'interface radio ainsi constitué sont utilisés pour connecter ce dispositif d'interface radio à d'autres dispositifs d'interface radio, ou à d'autres dispositifs complémentaires compatibles (tel que des dispositifs de commande ou des dispositifs d'interface à d'autres réseaux, par exemple à Internet).

Un dispositif d'interface radio ainsi constitué peut donc prendre en charge une technologie d'accès radio donnée dans une bande de fréquences donnée. Il est également possible de le qualifier par une dimension, correspondant au nombre de modems radio numériques qu'il comprend (par analogie à ce qui a été défini en lien avec le module d'interface radio analogique). Ainsi, dans le cadre de ce document, un dispositif d'interface radio LoRa™ 868MHz de dimension 3 est un dispositif d'interface radio formé par assemblage de trois modems radio numériques reposant sur la technologie d'accès radio LoRa™, associés à un même module d'interface radio analogique opérant dans la bande de fréquences 868MHz. La dimension est un indicateur de la charge (en termes de nombre de capteurs sans-fil) qu'un dispositif d'interface radio est apte à gérer.

### 5.7.4 Exemples de configurations de passerelles

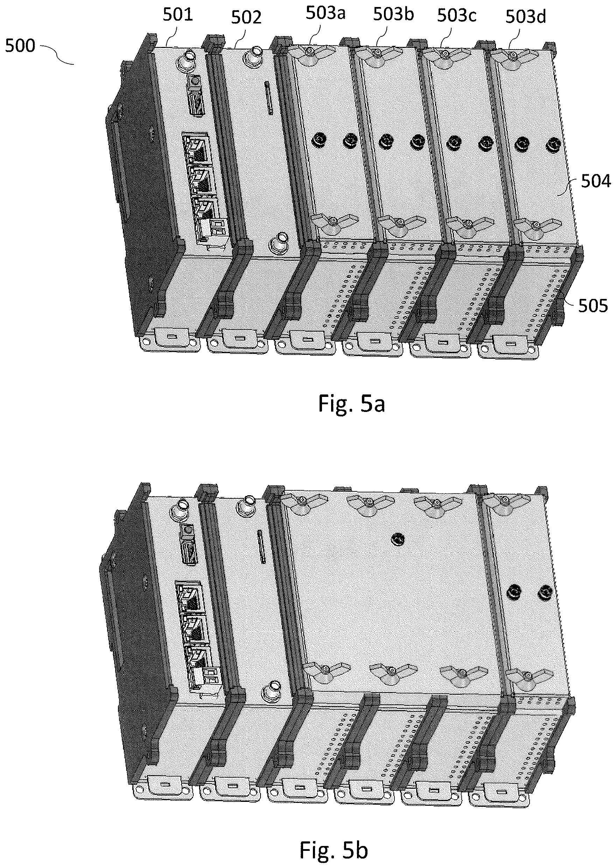

On présente, en relation avec les **figures 5a à 5c****,** différentes configurations de passerelles, données à titre purement illustratives et non limitatives, qui peuvent être mises en oeuvre très simplement grâce à la technique proposée.

Ces configurations font apparaître d'autres dispositifs complémentaires, en plus des modems radio numériques et des modules d'interface radio analogique qui leurs sont associés. Il peut s'agir de dispositifs complémentaires obligatoires ou optionnels pour la constitution d'une architecture de passerelle. Ainsi, dans un mode de réalisation particulier présenté par exemple en relation avec la figure 5a, une passerelle (500) selon la technique proposée comprend un dispositif complémentaire de contrôle (501), destiné à assurer d'une part l'alimentation électrique de l'ensemble de la passerelle (ce dispositif étant par exemple connecté à une prise électrique classique, ou encore alimenté directement par câble Ethernet selon la technologie PoE, de l'anglais « Power over Ethernet »), et à contrôler d'autre part l'ensemble des autres dispositifs complémentaires et dispositifs d'interface radio. Des dispositifs complémentaires d'interface (502), permettant différents types d'interconnexion (en Ethernet, en WiFi, en 3G/4G, etc.) avec d'autres réseaux locaux ou étendus, peuvent également être mis en oeuvre. Dans le mode de réalisation particulier exposé ici chacun de ces dispositifs complémentaires comprend un châssis de protection de dimensions sensiblement équivalentes à celles d'un modem radio numérique selon la technique proposée. Tout comme ceux des modems radio numériques, ces châssis comprennent respectivement sur leurs faces supérieures et inférieures, au moins un connecteur SPI mâle et au moins un connecteur SPI femelle aptes à coopérer avec les connecteurs SPI d'un autre dispositif, lorsque ces dispositifs sont assemblés. Ces connecteurs SPI mâles et femelles forment des extrémités respectives d'au moins un bus de données interne au châssis. Aussi, la coopération des différents connecteurs SPI, lorsque plusieurs dispositifs sont assemblés les uns aux autres, permet à l'ensemble des dispositifs ainsi chaînés de communiquer entre eux au moyen du bus de communication commun alors établi.

La figure 5a présente un exemple de passerelle comprenant quatre dispositifs d'interface radio (503a, 503b, 503c, 503d) pour la réception et la transmission de données en provenance et à destination de capteurs sans-fil, chacun de ces dispositifs d'interface radio comprenant un unique modem radio numérique associé chacun à un unique module d'interface radio analogique. Le dispositif d'interface radio (503d) est par exemple formé par l'assemblage du modem radio numérique (505) avec le module d'interface radio analogique (504). Une telle configuration peut par exemple comprendre trois dispositifs d'interface radio prenant en charge la technologie d'accès radio LoRa dans la bande de fréquences 868MHz, chacun étant associé à une antenne sectorisée (tri-sectorisation) ; et un dispositif d'interface radio prenant en charge la technologie d'accès radio WM-Bus dans la bande de fréquences 169MHz, associé à une antenne omnidirectionnelle. De cette manière, la passerelle ainsi constituée est apte à prendre en charge deux types de technologies d'accès radio, l'une (LoRa™) pour communiquer avec des objets connectés, et l'autre (WM-Bus) avec des compteurs électricité ou gaz afin de réaliser de la télérelève par exemple. Si la technologie LoRa™ doit être opérée dans une autre bande de fréquences, par exemple en cas de transposition d'une solution existante dans un territoire à la réglementation différente en termes de radiocommunication, la passerelle peut être adaptée très facilement à cette nouvelle situation, simplement en remplaçant les trois modules d'interface radio analogique configurés pour la bande 868MHz par trois autres configurés pour la bande de fréquences souhaitée, par exemple la bande 915MHz. Si, dans un autre exemple, la technologie LoRa™ doit être opérée dans la bande de fréquences 433Mhz, et qu'il est souhaité pour une raison quelconque d'utiliser une seule antenne omnidirectionnelle plutôt que trois antennes sectorisées, les trois modules d'interface radio analogique configurés pour la bande 868MHz peuvent être très simplement remplacé par un unique module d'interface radio analogique de dimension trois, configuré pour la bande 433MHz. Cette configuration de passerelle est alors illustrée par le figure 5b, qui présente un exemple de passerelle comprenant deux dispositifs d'interface radio pour la réception et la transmission de données en provenance et à destination de capteurs sans-fil : un premier dispositif d'interface radio comprenant trois modems radio numériques associés au même module d'interface radio analogique, et un deuxième dispositif d'interface radio ce dispositif d'interface radio comprenant un unique modem radio numérique associé à un unique module d'interface radio analogique.

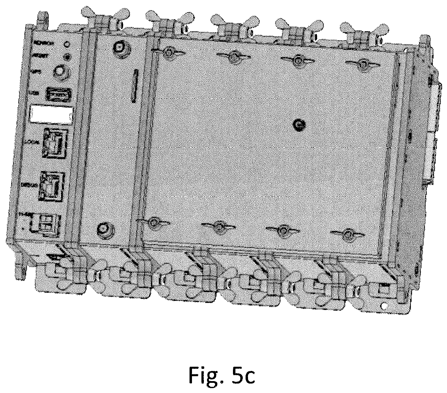

La figure 5c présente enfin un exemple de passerelle comprenant un seul dispositif d'interface radio pour la réception et la transmission de données en provenance et à destination de capteurs sans-fil, ce dispositif d'interface radio comprenant lui-même quatre modems radio numériques associés au même module d'interface radio analogique. Ce dispositif d'interface radio est par exemple associé à une antenne omnidirectionnelle. Dans ce cas, la passerelle ne gère qu'une seule technologie d'accès radio, mais la multiplication des modems radio numériques fait qu'elle est à apte à gérer un grand nombre de capteurs.

Il convient de noter que, si les passerelles présentées dans les figures 5a à 5c comprennent toutes quatre modems radio numériques (répartis en un nombre variable de dispositifs d'interface radio), il ne s'agit là que d'exemples donnés à titre purement illustratif et non limitatif: une passerelle selon la technique proposée comprend un ou plusieurs modems radio numériques et un ou plusieurs modules d'interface radio analogique, un modem radio numérique étant toujours couplé à un seul module d'interface radio analogique, mais un même module d'interface radio analogique pouvant être associé à plusieurs modem radio numérique.

A la vue de ces exemples, l'Homme du Métier appréciera aisément les potentialités offertes par la technique proposée, tant en termes de modularité que d'évolutivité. La possibilité d'assembler très facilement des modems radio numériques avec un module d'interface radio analogique pour former un dispositif d'interface radio, ajoutée à la possibilité d'assembler plusieurs dispositifs d'interface radio ainsi constitués au sein d'une même passerelle, offrent en effet une solution élégante aux différentes problématiques qui peuvent se poser en lien avec le déploiement ou la maintenance de réseaux de capteurs sans-fil à grande échelle. Cette architecture de passerelle modulable permet de prendre en compte la diversité des technologies d'accès radio existantes et à venir, la diversité des fréquences utilisées pour la transmission radio, les différentes typologies d'antennes, et l'adaptation au nombre de capteurs à adresser.

A titre d'exemples, les quelques cas d'utilisation suivants montrent des réponses pouvant être apportées par la technique proposée à différentes situations susceptibles d'être rencontrées lors du déploiement de réseaux de capteurs à grande échelle :
- Besoin de supporter simultanément plusieurs réseaux de capteurs sans-fil basés sur des protocoles différents (par exemple un réseau LoRa™ et un réseau WM-Bus) : avec la technique proposée, le support multi-technologies d'accès radio est facilement réalisé par simple assemblage d'au moins un dispositif d'interface radio adapté à chaque technologie d'accès radio à prendre en charge (par exemple, assemblage au sein de la passerelle d'un dispositif d'interface radio comprenant un ou plusieurs modems radio numériques LoRa™, et d'un dispositif d'interface radio comprenant un ou plusieurs modems radio numériques WM-Bus).
- Besoin de gérer plusieurs bandes de fréquences pour la transmission radio, pour une même technologie d'accès radio (par exemple supporter la technologie LoRa™ simultanément dans les bandes 433Mhz et 868MHz) : avec la technique proposée, le support multi-bandes est réalisé simplement en assemblant au moins un dispositif d'interface radio adapté à chaque bande de fréquences à gérer (par exemple, assemblage au sein de la passerelle d'un dispositif d'interface radio LoRa™ comprenant un module d'interface radio analogique 433MHz, et d'un dispositif d'interface radio LoRa™ comprenant un module d'interface radio analogique 868MHz).
- Besoin de passer d'une antenne omnidirectionnel à une configuration à trois antennes tri-sectorisée (et inversement) : avec la technique proposée, la sectorisation peut-être mise en oeuvre simplement, en assemblant un dispositif d'interface radio de même type (même technologie d'accès radio, même bande de fréquences) par secteur à couvrir, chacun de ces dispositifs d'interface radio étant connecté à sa propre antenne sectorisée (par exemple, assemblage de trois dispositifs d'interface radio Sigfox 915MHz de dimension un). A l'inverse, le passage d'une configuration de type tri-sectorisation à une configuration mono-antenne (antenne omnidirectionnelle) peut également être effectuée très simplement, en remplaçant par exemple les modules d'interface radio analogique de dimension un associés au dispositif d'interface radio de chaque secteur par un seul module d'interface radio analogique de dimension trois auquel sera connecté l'antenne omnidirectionnelle (on passe alors par exemple d'une configuration à trois dispositifs d'interface radio Sigfox 915MHz de dimension un à une configuration à un dispositif d'interface radio Sigfox 915MHz de dimension trois).
- Besoin de modifier la charge (en termes de nombre de capteurs) qu'un dispositif d'interface radio peut supporter : avec la technique proposée, l'adaptation de la capacité peut être mise en oeuvre simplement en remplaçant le dispositif d'interface radio ciblé par un dispositif d'interface radio de même type (même technologie d'accès radio, même bande de fréquences), mais de dimension inférieure (si on souhaite gérer moins de capteurs) ou supérieure (si on souhaite gérer plus de capteurs).
- Besoin de gérer un nouveau type de connexion à un autre réseau étendu (par exemple gérer une liaison WiFi) : avec la technique proposée, l'évolution des possibilités de connectivité d'une passerelle est réalisée simplement, par simple ajout ou remplacement d'un dispositif complémentaire compatible.

Ces exemples sont donnés à titre purement illustratifs et non limitatifs, et il apparaîtra clairement à l'Homme du Métier que la technique proposée est en mesure de répondre à un nombre important de situations, y compris des situations complexes pour lesquelles il est nécessaire d'adapter simultanément de nombreux paramètres (modification de la technologie d'accès radio, concomitante à une modification de la bande de fréquences et de la typologie d'antennes à utiliser, et à une modification du nombre de capteurs à gérer, par exemple).

### 5.7.5. Autres caractéristiques et avantages

D'autres caractéristiques notables sont présentées ici, en relation avec l'architecture de passerelle présentée selon le mode de réalisation particulier illustré par les figures 2 à 5.

Il peut être intéressant de noter, par exemple, qu'aucun câble externe n'est nécessaire pour connecter les différents blocs physiques constitutifs de la passerelle (modems radio numériques, modules d'interface radio analogique associés, dispositifs complémentaires) : les châssis de ces différents dispositifs sont en effet conformés et dimensionnés afin qu'ils puissent être assemblés par emboitage des différents connecteurs complémentaires respectifs présent sur leurs différentes faces, et que l'assemblage final présente une forme compacte et globalement parallélépipédique, qui simplifie son installation et son intégration dans tout type d'environnement.

Les différents châssis mis en oeuvre comprennent également, dans certains modes de réalisation particuliers, des caractéristiques destinées à assurer une solidarisation efficace des blocs constitutifs d'une passerelle selon la technique proposée, afin notamment de prévenir toute déconnexion intempestive de ces différents blocs.

Ainsi, les modems radio numériques et les modules d'interface radio analogique disposent de moyens de solidarisation complémentaires. Par exemple, le châssis d'un modem radio numérique peut comprendre un ou plusieurs trous taraudés, aptes à accueillir des vis papillon complémentaires traversant le châssis d'un module d'interface radio analogique associé.

Les modems radio numériques disposent également de moyens permettant de contribuer à assurer leur solidarisation entre eux ou avec des dispositifs complémentaires. Ces moyens peuvent par exemple prendre la forme d'une excroissance du châssis de ces dispositifs, dans laquelle est pratiquée un trou, de sorte que tous les trous ainsi ménagés soient en vis-à-vis une fois les différents dispositifs constitutifs de la passerelle emboîtés. Ces trous peuvent alors permettre le passage de divers moyens de solidarisation (tige filetée et boulonnage, collier, etc.).

Les châssis des modems radio numériques et des dispositifs complémentaires comprennent des moyens permettant de fixer une passerelle pour réseaux de capteurs sans-fil assemblée selon la technique proposée dans une armoire ou dans une baie de protection classique.

Dans un mode de réalisation de la technique proposée, le châssis des différents blocs physique constituant la passerelle, et notamment le châssis des modules d'interface radio analogique, est par ailleurs conçu de telle sorte qu'il fasse office de cage de Faraday, afin de protéger ces modules des perturbations électromagnétiques auxquelles ils pourraient être soumis. Dans un autre mode de réalisation, une plaque faisant office de bouclier de protection et jouant ce rôle de cage de Faraday peut être fixée en couverture des modules d'interface radio analogiques.

## Revendications

1. Modem radio numérique (200) pour la modulation et la démodulation d'un signal numérique en fonction d'une technologie d'accès radio préalablement sélectionnée, ledit modem radio numérique comprend un châssis de protection (201) de forme globalement parallélépipédique et une pluralité d'interfaces de communication aménagées au sein dudit châssis de protection (201), ledit modem radio numérique étant **caractérisé en ce que** la pluralité d'interfaces de communication comprend :
au moins deux premières interfaces de communication avec un dispositif complémentaire,
une des premières interface de communication comprenant :
- sur une des faces du châssis de protection (201), dite face supérieure (202), deux connecteurs SPI mâles (203, 203') ;
une autre des premières interface de communication comprenant :
- sur une face du châssis de protection (201) opposée à ladite face supérieure (202), dite face inférieure (204), deux connecteurs SPI femelles (205, 205'), aptes à coopérer avec les deux connecteurs SPI mâles (203, 203') d'un autre modem radio numérique, de manière à ce que lorsque plusieurs modems radio numériques sont connectés, les connecteurs SPI mâles (203, 203') et femelles (205, 205') forment des extrémités respectives d'au moins un bus de données SPI, interne au châssis de protection (201), utilisé par le modem radio numérique pour transmettre et recevoir des données à destination et en provenance du ou des modems radio numériques auquel il est connecté;
au moins une deuxième interface de communication avec un module d'interface radio analogique, la deuxième interface de communication comprenant :
sur une des faces latérales du châssis de protection (201), dite face arrière (206), au moins un autre connecteur SPI (207) et au moins un connecteur coaxial (208) destinés à coopérer avec des connecteurs complémentaires présents sur un module d'interface radio analogique.

2. Modem radio numérique numérique selon la revendication 1, **caractérisé en ce que** ladite technologie d'accès radio préalablement sélectionnée est choisie, parmi un ensemble de technologies d'accès radio prédéfinies au sein dudit modem radio numérique.

3. Modem radio numérique selon l'une des revendications précédentes, disposant de moyens de solidarisation complémentaires de moyens de solidarisation dudit module d'interface radio analogique.

4. Modem radio numérique selon la revendication précédente, dans lequel le châssis de protection (201) du modem radio numérique comprend un ou plusieurs trous taraudés, aptes à accueillir des vis papillon complémentaires traversant le châssis de protection (201) dudit module d'interface radio analogique associé.

5. Modem radio numérique selon l'une des revendications précédentes, le modem radio numérique disposant de moyens permettant de contribuer à assurer sa solidarisation avec d'autres modems radio numériques ou avec des dispositifs complémentaires.

6. Modem radio numérique selon la revendication précédente, dans lequel les moyens permettant de contribuer à assurer la solidarisation du modem radio numérique avec d'autres modems radio numériques ou avec des dispositifs complémentaires comportent une excroissance du châssis de protection (201) du modem radio numérique, dans laquelle est pratiquée un trou, de sorte que le trou ainsi ménagé soit en vis-à-vis de trous pratiqués dans lesdits autres modems radio numériques ou dans lesdits dispositifs complémentaires, une fois les différents dispositifs emboîtés.

7. Module d'interface radio analogique (300) comprenant un châssis de protection (301) de forme globalement parallélépipédique, des moyens de connexion à au moins une antenne, ledit module d'interface radio analogique étant **caractérisé en ce qu'**il comprend au moins une troisième interface de communication avec un modem radio numérique selon l'une quelconque des revendications 1 à 6, lesdits moyens de connexion à au moins une antenne et ladite au moins une troisième interface de communication étant aménagés au sein dudit châssis de protection (301),
les moyens de connexion à au moins une antenne comprenant :
- sur une des faces du châssis de protection (301), dite face arrière (302), au moins un connecteur coaxial (303) destiné au branchement d'au moins une antenne,
la troisième interface de communication avec un modem radio numérique comprenant :
- sur une face du châssis de protection (301) opposée à ladite face arrière, dite face avant (304), au moins un connecteur SPI (305) et au moins un connecteur coaxial (306), ces connecteurs (305, 306) étant aptes à coopérer respectivement avec des connecteurs respectifs complémentaires présents sur une face arrière d'un modem radio numérique selon l'une des revendications 1 à 6,
le châssis de protection (301) du module d'interface radio analogique étant dimensionné et conformé de sorte que sa face avant présente une dimension sensiblement équivalente à celle de N faces arrière de modems radio numériques destinés à être disposés côte-à-côte, N étant un entier supérieur ou égal à 1.

8. Module d'interface radio analogique (300) selon la revendication 7, configuré pour être connecté à un modem radio numérique selon l'une des revendications 1 à 6, dans lequel la face avant (304) du châssis de protection (301) du module d'interface radio analogique présente une dimension sensiblement équivalente à celle de la face arrière dudit modem radio numérique.

9. Module d'interface radio analogique (300) selon la revendication 7, configuré pour être connecté simultanément à un nombre N de modems radio numériques selon l'une des revendications 1 à 6, les modems radio numériques étant destinés à être disposés côte-à-côte et interconnectés, dans lequel la face avant (304) du châssis de protection (301) du module d'interface radio analogique présente une dimension sensiblement équivalente à celle de N faces arrière desdits modems radio numériques.

10. Module d'interface radio analogique (300) selon l'une des revendications 7 à 9, dans lequel le châssis de protection (301) du module d'interface radio analogique, est conçu de telle sorte qu'il fasse office de cage de Faraday.

11. Dispositif d'interface radio pour la réception et la transmission de données en provenance et à destination d'au moins un capteur sans-fil, ledit dispositif étant **caractérisé en ce qu'**il comprend :
- au moins un modem radio numérique selon l'une quelconque des revendications 1 à 6;
- un module d'interface radio analogique selon l'une des revendications 7 à 10, connecté audit au moins un modem radio numérique au moyen d'une coopération desdites deuxième et troisième interfaces de communication.

12. Dispositif d'interface radio selon la revendication 11 **caractérisé en ce qu'**il comprend une pluralité de modems radio numériques selon l'une quelconque des revendications 1 à 6, associés à une même technologie d'accès radio, lesdits modems radio numériques de ladite pluralité de modems radio numériques étant connectés entre eux au moyen desdites premières interfaces de communication.

13. Passerelle (500) pour l'interconnexion d'au moins un réseau de capteurs sans-fil avec au moins un réseau de communication étendu, ladite passerelle étant **caractérisé en ce qu'**elle comprend :
- au moins un dispositif d'interface radio selon l'une quelconque des revendications 11 et 12, pour l'échange de données avec lesdits capteurs sans-fil ;
- au moins un dispositif complémentaire d'interface (502) avec ledit au moins un réseau de communication étendu, ledit dispositif complémentaire d'interface (502) comprenant au moins une quatrième interface de communication, ledit dispositif complémentaire d'interface (502) étant connecté audit au moins un dispositif d'interface radio au moyen d'une coopération de ladite quatrième interface de communication avec une première interface de communication d'un modem radio numérique dudit dispositif d'interface radio, le dispositif complémentaire d'interface (502) comprenant un châssis de protection de dimensions sensiblement équivalentes à celles d'un châssis de protection (201) d'un modem radio numérique,
la quatrième interface de communication comprenant, sur une face supérieure et inférieure du châssis de protection du dispositif complémentaire d'interface (502), au moins un connecteur SPI mâle et au moins un connecteur SPI femelle aptes à coopérer avec les connecteurs SPI d'un modem radio numérique ou d'un autre dispositif complémentaire d'interface (502), les connecteurs SPI mâles et femelles formant des extrémités respectives d'au moins un bus de données interne au châssis.

14. Passerelle selon la revendication 13 **caractérisé en ce qu'**elle comprend une pluralité de dispositifs d'interface radio selon l'une quelconque des revendications 11 et 12, lesdits dispositifs d'interface radio de ladite pluralité de dispositifs d'interface radio étant connectés entre eux au moyen d'une coopération de premières interfaces de communication des modems radio numériques de ladite pluralité de dispositifs d'interface radio.

15. Passerelle selon l'une des revendications 13 et 14, dans laquelle les châssis de protection des modems radio numériques et des dispositifs complémentaires comprennent des moyens permettant de fixer la passerelle pour réseaux de capteurs sans-fil dans une armoire ou dans une baie de protection.

## Patentansprüche

1. Digitales Funkmodem (200) zum Modulieren und Demodulieren eines digitalen Signals gemäß einer zuvor ausgewählten Funkzugangstechnologie, wobei das digitale Funkmodem einen im Wesentlichen quaderförmigen Schutzrahmen (201) und eine Vielzahl von Kommunikationsschnittstellen, welche im Inneren des Schutzrahmens (201) angeordnet sind, umfasst,
wobei das digitale Funkmodem **dadurch gekennzeichnet ist, dass**
die Vielzahl der Kommunikationsschnittstellen umfasst:
mindestens zwei erste Kommunikationsschnittstellen mit einer zusätzlichen Vorrichtung,
wobei eine der ersten Kommunikationsschnittstellen umfasst:
- auf einer der Seiten des Schutzrahmens (201), nämlich der Oberseite (202), zwei SPI Stecker (203, 203');
wobei eine andere der ersten Kommunikationsschnittstellen umfasst:
- auf einer Seite des Schutzrahmens (201), welche gegenüber der Oberseite (202) liegt, nämlich der Unterseite (204), zwei SPI Buchsen (205, 205'), welche mit den zwei SPI Steckern (203, 203') eines anderen digitalen Funkmodems zusammenwirken können, so dass, wenn mehrere digitale Funkmodems miteinander verbunden sind, die SPI Stecker (203, 203') und die SPI Buchsen (205, 205') die jeweiligen Endabschnitte eines SPI Datenbusses im Inneren des Schutzrahmens (201) bilden, welcher vom digitalen Funkmodem zur Übertragung und Empfangen von Daten zu und von dem oder den digitalen Funkmodems, mit dem es verbunden ist, nutzbar ist;
mindestens eine zweite Kommunikationsschnittstelle mit einem analogen Funkschnittstellenmodul, wobei die zweite Kommunikationsschnittstelle umfasst:
auf einer der Seitenflächen des Schutzrahmens (201), nämlich der Rückseite (206), mindestens einen weiteren SPI Verbinder (207) und mindestens einen Koaxialverbinder (208), welche dazu geeignet sind, mit dem zusätzlichen Verbinder des analogen Funkschnittstellenmoduls zusammenzuwirken.

2. Digitales Funkmodem gemäß Anspruch 1, **dadurch gekennzeichnet, dass** die zuvor ausgewählte Funkzugangstechnologie auswählbar ist aus einer Gesamtheit von vordefinierten Funkzugangstechnologien innerhalb des digitalen Funkmodems.

3. Digitales Funkmodem gemäß einem der vorgehenden Ansprüche, wobei das komplementäre Befestigungsmittel zu den Befestigungsmitteln des analogen Funkschnittstellenmoduls aufweist.

4. Digitales Funkmodem gemäß dem vorstehenden Anspruch, wobei der Schutzrahmen (201) des digitalen Funkmodems eine oder mehrere Gewindebohrungen umfasst, welche dazu geeignet sind, komplementäre Flügelschrauben, welche den Schutzrahmen (201) des verbundenen analogen Funkschnittstellenmoduls durchqueren, aufzunehmen.

5. Digitales Funkmodem gemäß einem der vorstehenden Ansprüche, wobei das digitale Funkmodem Mittel umfasst, welche es ermöglichen, die Verbindung mit anderen digitalen Funkmodems oder zusätzlichen Vorrichtungen sicherzustellen.

6. Digitales Funkmodem gemäß dem vorstehenden Anspruch, wobei die Mittel, welche die Verbindung des digitalen Funkmodems mit anderen digitalen Funkmodems oder zusätzlichen Vorrichtungen sicherstellen, einen Vorsprung des Schutzrahmens (201) des digitalen Funkmodems umfassen, wobei in dem Vorsprung ein Loch eingebracht ist, so dass das so eingebrachte Loch gegenüber den in den anderen digitalen Funkmodems oder zusätzlichen Vorrichtungen eingebrachten Löchern angeordnet ist, wenn die verschiedenen Einrichtungen miteinander verbunden sind.

7. Analoges Funkschnittstellenmodul (300) umfassend einen im Wesentlichen quaderförmigen Schutzrahmen (301), Verbindungsmittel mit mindestens einer Antenne, wobei das analoge Funkschnittstellenmodul **dadurch gekennzeichnet ist, dass** es mindestens eine dritte Kommunikationsschnittstelle mit einem digitalen Funkmodem gemäß Anspruch 1 bis 6 umfasst, wobei die Verbindungsmittel mit mindestens einer Antenne und die dritte Kommunikationsschnittstelle im Inneren des Schutzrahmens (301) angeordnet sind,
wobei die Verbindungsmittel mit mindestens einer Antenne umfassen:
- auf einer der Seiten des Schutzrahmens (301), nämlich der Rückseite (302), mindestens einen Koaxialverbinder (303), welcher dazu geeignet ist, mindestens eine Antenne anzuschließen,
wobei die dritte Kommunikationsschnittstelle mit einem digitalem Funkmodem umfasst:
- auf einer Seite des Schutzrahmens (301), welche gegenüber der Rückseite liegt, nämlichder Vorderseite (304), mindestens einen SPI Verbinder (305) und mindestens einen Koaxialverbinder (306), wobei diese Verbinder (305, 306) dazu geeignet sind, jeweils mit den jeweiligen komplementären Verbinder, welche auf einer Rückseite eines digitalen Funkmodems gemäß einem der Ansprüche 1 bis 6 angeordnet sind, zusammenzuwirken,
wobei der Schutzrahmen (301) des analogen Funkschnittstellenmoduls so bemessen und geformt ist, dass seine Vorderseite eine Abmessung aufweist, die im Wesentlichen der von N Rückseiten von digitalen Funkmodems entspricht, die nebeneinander angeordnet sind, wobei N eine ganze Zahl größer oder gleich 1 ist.

8. Analoges Funkschnittstellenmodul (300) gemäß Anspruch 7, konfiguriert zur Verbindung mit einem digitalen Funkmodem gemäß einem der Ansprüche 1 bis 6, wobei die Vorderseite (304) des Schutzrahmens (301) des analogen Funkschnittstellenmoduls eine Abmessung aufweist, die im Wesentlichen derjenigen der Rückseite des digitalen Funkmodems entspricht.

9. Analoges Funkschnittstellenmodul (300) gemäß Anspruch 7, konfiguriert, um gleichzeitig mit einer Anzahl N von digitalen Funkmodems gemäß einem der Ansprüche 1 bis 6 verbunden zu sein, wobei die digitalen Funkmodems dazu bestimmt sind, nebeneinander angeordnet und verbunden zu sein, wobei die Vorderseite (304) des Schutzrahmens (301) des analogen Funkschnittstellenmoduls eine Abmessung aufweist, die im Wesentlichen gleichwertig ist mit N Rückseiten der digitalen Funkmodems.

10. Analoges Funkschnittstellenmodul (300) gemäß einem der Ansprüche 7 bis 9, wobei das Schutzgehäuse (301) des analogen Funkschnittstellenmoduls so ausgelegt ist, dass es als faradayscher Käfig verwendbar ist.

11. Funkschnittstellenvorrichtung zum Empfangen und Übertragen von Daten von und zu mindestens einem drahtlosen Sensor, wobei die Vorrichtung **dadurch gekennzeichnet ist, dass** sie umfasst:
- mindestens ein digitales Funkmodem gemäß einem der Ansprüche 1 bis 6;
- ein analoges Funkschnittstellenmodul gemäß einem der Ansprüche 7 bis 10, welches mit mindestens einem digitalen Funkmodem mittels eines Zusammenwirkens der ersten und zweiten Kommunikationsschnittstelle verbunden ist.

12. Funkschnittstellenvorrichtung gemäß Anspruch 11, **dadurch gekennzeichnet, dass** sie eine Vielzahl von digitalen Funkmodems gemäß einem der Ansprüche 1 bis 6 umfasst, welche mit einer gleichen Funkzugangstechnologie verbunden sind, wobei die digitalen Funkmodems aus der Vielzahl der digitalen Funkmodems miteinander mittels der ersten Kommunikationsschnittstellen verbunden sind.

13. Gateway (500) zum Verbinden von mindestens einem drahtlosen Sensornetzwerk mit mindestens einem Breitband-Kommunikationsnetzwerk, wobei das Gateway **dadurch gekennzeichnet, dass** es umfasst:
- mindestens eine Funkschnittstellenvorrichtung gemäß einem der Ansprüche 11 bis 12 zum Austausch von Daten mit dem drahtlosen Sensor;
- mindestens eine zusätzliche Schnittstellenvorrichtung (502) mit dem mindestens einem Breitband-Kommunikationsnetzwerk, wobei die zusätzliche Schnittstellenvorrichtung (502) mindestens eine vierte Kommunikationsschnittstelle umfasst, wobei die zusätzliche Schnittstellenvorrichtung (502) an mindestens einer Funkschnittstellenvorrichtung mittels eines Zusammenwirkens der vierten Kommunikationsschnittstelle mit einer ersten Kommunikationsschnittstelle eines digitalen Funkmodems der Funkstellenvorrichtung verbunden ist, wobei die zusätzliche Schnittstellenvorrichtung (502) einen Schutzrahmen mit einer Abmessung, die im Wesentlichen derjenigen des Schutzrahmens (201) eines Funkmodems entspricht, umfasst,
die vierte Kommunikationsschnittstelle umfasst auf einer Ober- und Unterseite des Schutzrahmens der zusätzlichen Schnittstellenvorrichtung (502) mindestens einen SPI Stecker und mindestens eine SPI Buchse, welche dazu geeignet sind, mit dem SPI Verbinder eines digitalen Funkmodems oder einer anderen zusätzlichen Schnittstellenvorrichtung (502) zusammenzuwirken, wobei der SPI Stecker und die SPI Buchse die jeweiligen Endabschnitte eines SPI Datenbusses im Inneren des Schutzrahmens bilden.

14. Gateway gemäß Anspruch 13, **dadurch gekennzeichnet, dass** es eine Vielzahl von Funkschnittstellenvorrichtungen gemäß einem der Ansprüche 11 bis 12 umfasst, wobei die Funkschnittstellenvorrichtungen der Vielzahl der Funkschnittstellenvorrichtungen miteinander mittels eines Zusammenwirkens der ersten Kommunikationsschnittstellen des digitalen Funkmodems der Vielzahl der Funkschnittstellenvorrichtungen verbunden sind.

15. Gateway gemäß einem der Ansprüche 13 bis 14, wobei die Schutzrahmen der digitalen Funkmodems und der zusätzlichen Vorrichtungen Mittel umfassen, die es ermöglichen, das drahtlose Sensornetzwerk-Gateway in einem Schaltschrank oder einem Schutzraum zu befestigen.

## Claims

1. A digital radio modem (200) for the modulation and demodulation of a digital signal, in accordance with a preselected radio access technology, said digital radio modem comprising a protective frame (201) of overall parallelepipedic design and a plurality of communication interfaces which are arranged within said protective frame (201),
Said digital radio modem being **characterized in that** the plurality of communication interfaces comprises:
at least two first communication interfaces with a complementary device,
one of the first communication interfaces comprising:
- on one of the surfaces of the protective frame (201), described as the "upper surface" (202), two male SPI connectors (203, 203');
another of the first communication interfaces comprises:
- on the opposing surface of the protective frame (201) to said upper surface (202), described as the "lower surface" (204), two female SPI connectors (205, 205'), which are designed to cooperate with the two male SPI connectors (203, 203') of another digital radio modem such that, when a plurality of digital radio modems are connected, the male (203, 203') and female (205, 205') SPI connectors constitute the respective terminations of at least one SPI data bus, arranged internally to the protective frame (201), and employed by the digital radio modem for the transmission and reception of data to and from the digital radio modem(s) to which it is connected;
at least one second communication interface with an analog radio interface module, the second communication interface comprising:
on one of the lateral surfaces of the protective frame (201), described as the "rear surface" (206), at least one other SPI connector (207) and at least one coaxial connector (208), which are designed to cooperate with the complementary connectors present on an analog radio interface module.

2. The digital radio modem as claimed in claim 1, **characterized in that** said preselected radio access technology is selected from a series of predefined radio access technologies within said digital radio modem.

3. The digital radio modem as claimed in one of the preceding claims, having complementary means of attachment to the means of attachment of said analog radio interface module.

4. The digital radio modem as claimed in the preceding claim, wherein the protective frame (201) of the digital radio modem incorporates one or more threaded holes, which are designed to accommodate complementary wing screws which pass through the protective frame (201) of said associated analog radio interface module.

5. The digital radio modem as claimed in one of the preceding claims, wherein the digital radio modem incorporates means which contribute to the attachment thereof to other digital radio modems, or to complementary devices.

6. The digital radio modem as claimed in the preceding claim, wherein the means which contribute to the attachment of the digital radio modem to other digital radio modems or to complementary devices comprise a protrusion on the protective frame (201) of the digital radio modem, in which a hole is formed, such that the hole thus formed is aligned with the holes formed in said other digital radio modems or in said complementary devices, once the various devices are interlocked.

7. An analog radio interface module (300) comprising a protective frame (301) of overall parallelepipedic design, connection means to at least one antenna, said analog radio interface module being **characterized in that** it comprises at least one third communication interface with a digital radio modem as claimed in any one of claims 1 to 6, said connection means to at least one antenna and said at least one third communication interface are arranged within said protective frame (301),
the connection means to the at least one antenna comprising:
- on one of the surfaces of the protective frame (301), described as the "rear surface" (302), at least one coaxial connector (303), which is designed for the connection of at least one antenna,
the third communication interface with a digital radio modem comprising:
- on an opposing surface of the protective frame (301) to said rear surface, described as the "front surface" (304), at least one SPI connector (305) and at least one coaxial connector (306), these connectors (305, 306) being designed to cooperate respectively with the respective complementary connectors which are arranged on a rear surface of a digital radio modem according to one of claims 1 to 6,
the protective frame (301) of the analog radio interface module being dimensioned and configured such that the front surface thereof is of substantially equivalent dimensions to the N rear surfaces of digital radio modems which are designed to be arranged side by side, where N is a whole number greater than or equal to 1.

8. The analog radio interface module (300) as claimed in claim 7, configured for connection to a digital radio modem as claimed in one of claims 1 to 6, wherein the front surface (304) of the protective frame (301) of the analog radio interface module is of substantially equivalent dimensions to the rear surface of said digital radio modem.

9. The analog radio interface module (300) as claimed in claim 7, configured for simultaneous connection to a number N of digital radio modems as claimed in one of claims 1 to 6, the digital radio modems are designed to be arranged side by side and interconnected, wherein the front surface (304) of the protective frame (301) of the analog radio interface module is of substantially equivalent dimensions to the N rear surfaces of said digital radio modems.

10. The analog radio interface module (300) as claimed in one of claims 7 to 9, wherein the protective frame (301) of the analog radio interface module is designed such that it functions as a Faraday cage.

11. A radio interface device for the reception and transmission of data from and to at least one wireless sensor, said device being **characterized in that** it comprises:
- at least one digital radio modem as claimed in any one of claims 1 to 6;
- an analog radio interface module as claimed in one of claims 7 to 10, connected to said at least one digital radio modem by means of the cooperation of said second and third communication interfaces.

12. The radio interface device as claimed in claim 11, **characterized in that** it comprises a plurality of digital radio modems as claimed in any one of claims 1 to 6, associated with a single radio access technology, said digital radio modems of said plurality of digital radio modems being mutually connected by means of said first communication interfaces.

13. A gateway (500) for the interconnection of at least one wireless sensor network with at least one wide-area communication network, said gateway being **characterized in that** it comprises:
- at least one radio interface device as claimed in either one of claims 11 and 12, for the exchange of data with said wireless sensors;
- at least one complementary interface device (502) with said at least one wide-area communication network, said complementary interface device (502) comprising at least one fourth communication interface, said complementary interface device (502) being connected to said at least one radio interface device by means of the cooperation of said fourth communication interface with a first communication interface of a digital radio modem of said radio interface device, the complementary interface device (502) comprising a protective frame of substantially equivalent dimensions to a protective frame (201) of a digital radio modem,
the fourth communication interface comprising, on an upper and lower surface of the protective frame of the complementary interface device (502), at least one male SPI connector and at least one female SPI connector, which are designed to cooperate with the SPI connectors of a digital radio modem or of another complementary interface device (502), the male and female SPI connectors constitute the respective terminations of at least one data bus which is arranged internally to the frame.

14. The gateway as claimed in claim 13, **characterized in that** it comprises a plurality of radio interface devices as claimed in either one of claims 11 and 12, said radio interface devices of said plurality of radio interface devices being mutually connected by means of the cooperation of the first communication interfaces of the digital radio modems of said plurality of radio interface devices.

15. The gateway as claimed in one of claims 13 and 14, wherein the protective frame of the digital radio modems and of the complementary devices comprises means for the attachment of the gateway for wireless sensor networks in a cabinet or in a protective bay.
